# EUROPEAN PATENT SPECIFICATION

(11) **EP 3 648 122 B1**
(45) Date of publication and mention of the grant of the patent: **09.12.2026**
(21) Application number: 18878702.2
(22) Date of filing: 15.10.2018
(51) Int. Cl.: H01C 7/06, H01C 7/20, H01C 1/144, G01R 1/20

(54) **SHUNT RESISTOR**
SHUNT-WIDERSTAND
RÉSISTANCE SHUNT

(30) Priority: 15.11.2017 JP 2017220342
(43) Date of publication of application: 06.05.2020
(73) Proprietor: Suncall Corporation, Kyoto-shi, Kyoto 615-8555 (JP)
(72) Inventor: MURAKAMI Kenji, Kyoto-shi Kyoto 615-8555 (JP)
(74) Representative: Hoffmann Eitle
(86) International application number: PCT/JP2018/038342
(87) International publication number: WO 2019/097924

(56) References cited:
- WO-A1-2007/062943
- DE-T5- 112012 002 861
- JP-A- 2011 003 694
- JP-A- 2017 011 087
- JP-A- S55 154 063
- US-A1- 2009 195 348
- US-A1- 2016 139 211
- US-A1- 2017 003 322

## Description

### [Technical Field]

The present invention relates to a shunt resistor, and in particular, to a shunt resistor used in measuring a current value of a current path through which a large current flows from a battery for high-voltage applications to a motor circuit that are used in, for example, electric vehicles (EVs), hybrid vehicles (HVs), and plug-in hybrid vehicles (PHVs).

### [Background Art]

A shunt resistor as described in Japanese Published Unexamined Patent Application No. 2017-009419 is known as a conventional shunt resistor. This shunt resistor is such that two plate-like base members sandwiching a resistor and integrally formed with the resistor are formed with respective through holes, and voltage detection terminals in which first terminal parts are inserted into the through holes and second terminal parts are projected from the through holes are provided.

Further examples of the prior art are described in documents WO 2007/062943 A1, US 2017/003322 A1, and DE 11 2012 002861 T5.

### [Summary of the Invention]

### [Problem to be Solved by the Invention]

However, the voltage detection terminals of the foregoing conventional resistor have a problem that a sufficient joining strength with respect to the base members has not been able to be obtained.

Accordingly, in view of the above problem, an object of the present invention is to provide a method for manufacturing a shunt resistor capable of obtaining a sufficient joining strength.

### [Means for Solving the Problem]

The above object of the present invention is achieved by the following means. It is noted that numerals in parentheses are reference numerals of embodiments to be described later, but the present invention should not be restricted thereto.

According to the first aspect of the present invention, a method for manufacturing a shunt resistor comprises the features of claim 1.

According to the first aspect of the present invention, the protruding part (12b) is formed in a tapered shape.

Further, according to the second aspect of the present invention, the method according to the above first aspect is characterized in that the electric resistance welding machine is an inverter-type or capacitor-type electric resistance welding machine, when the base member (11) is formed of copper and the measurement terminal (12) is formed of copper and the base member (11) and the measurement terminal (12) are joined together, the electric resistance welding machine can join them in a short time so that a structure of the joining part is not broken.

### [Effects of the Invention]

Next, effects of the present invention will be described giving reference numerals in the drawings. It is noted that numerals in parentheses are reference numerals of embodiments to be described later, but the present invention should not be restricted thereto.

According to the first aspect of the present invention, the protruding part (12b) integrally protruding from the distal end side of the shaft part (12a) is formed so as to be meltable by using an electric resistance welding machine. Therefore, if the protruding part (12b) is configured to be melted by using the electric resistance welding machine when the measurement terminal (12) is erected and fixed on the base member (11), the protruding part (12b) can weld the measurement terminal (12) erected and fixed on the base member (11), that is, the protruding part (12b) can be welded in close contact with the shaft part (12a). As a result, withstand loads in the axial direction (the upward direction) and the radial direction (the left/right direction) of the shaft part (12a) with respect to the base member (11) can be improved, whereby a sufficient joining strength can be obtained.

According to the first aspect of the present invention, the protruding part (12b) is formed in a tapered shape. Thus, a current is easily concentrated on the distal end surface (12b2) side of the protruding part (12b) when the shaft part (12a) is inserted into an electrode (I) of the electric resistance welding machine and a current is flowed in this state. As a result, the protruding part (12b) becomes easy to melt and can weld the shaft part (12a) on the base member (11) more firmly.

Further, according to the second aspect of the present invention, when the base member (11) is formed of copper and the measurement terminal (12) is formed of copper and the base member (11) and the measurement terminal (12) are joined together, the electric resistance welding machine can join them in a short time so that a structure of the joining part is not broken. Therefore, there is no chance that the structure of the joining part is broken whereby the resistance value is increased. Thus, the current value can be measured accurately.

### [Brief Description of the Drawings]

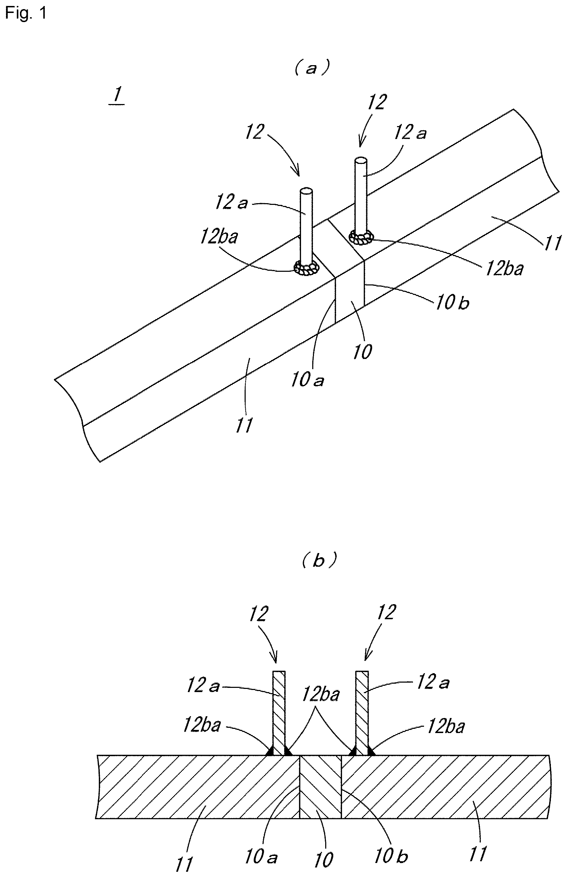

Fig. 1(a) is a perspective view of a shunt resistor according to one embodiment of the present invention, and Fig. 1(b) is a sectional view of the shunt resistor according to the same embodiment.

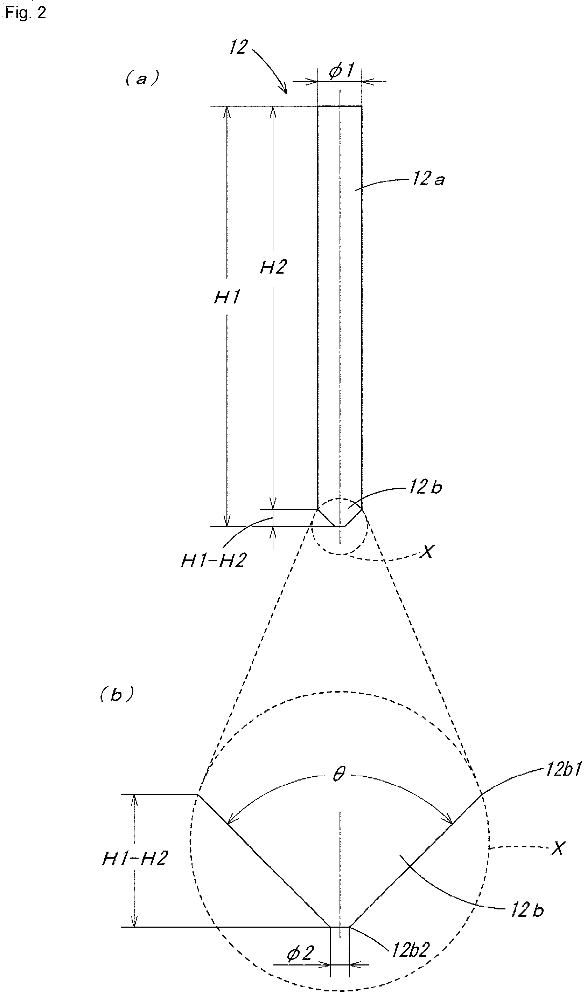

Fig. 2(a) is a front view of a measurement terminal according to the same embodiment, and Fig. 2(b) is an enlarged view of an X portion shown in Fig. 2(a).

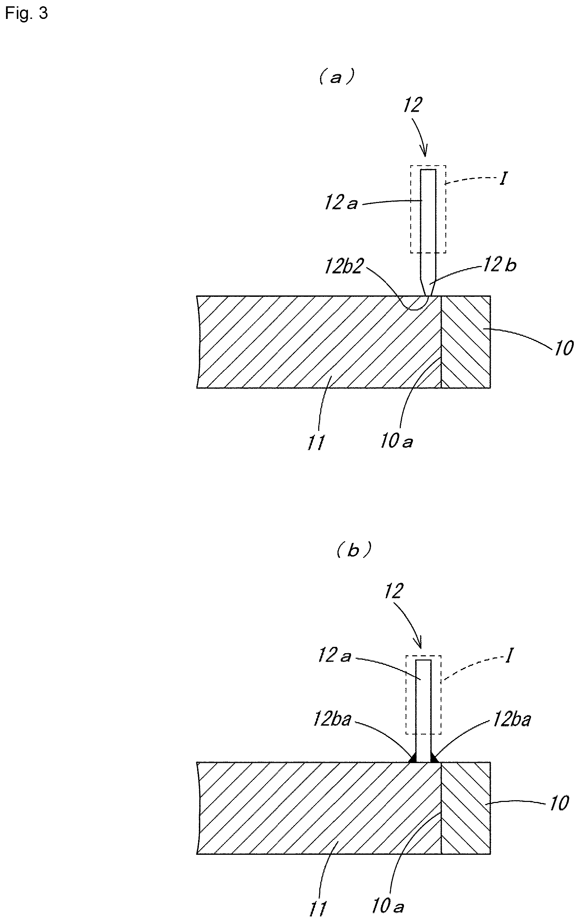

Fig. 3 shows a manufacturing process of the shunt resistor according to the same embodiment, and Fig. 3(a) is a partial half sectional view showing a state in which a distal end surface of a protruding part of the measurement terminal with its shaft part inserted in an electrode of an electric resistance welding machine is brought into contact with an upper surface of a base member, and Fig. 3(b) is a partial half sectional view showing a state in which the protruding part is melted by flowing a current to the electrode in the state shown in Fig. 3(a), whereby the base member and a side circumferential surface of the shaft part are welded.

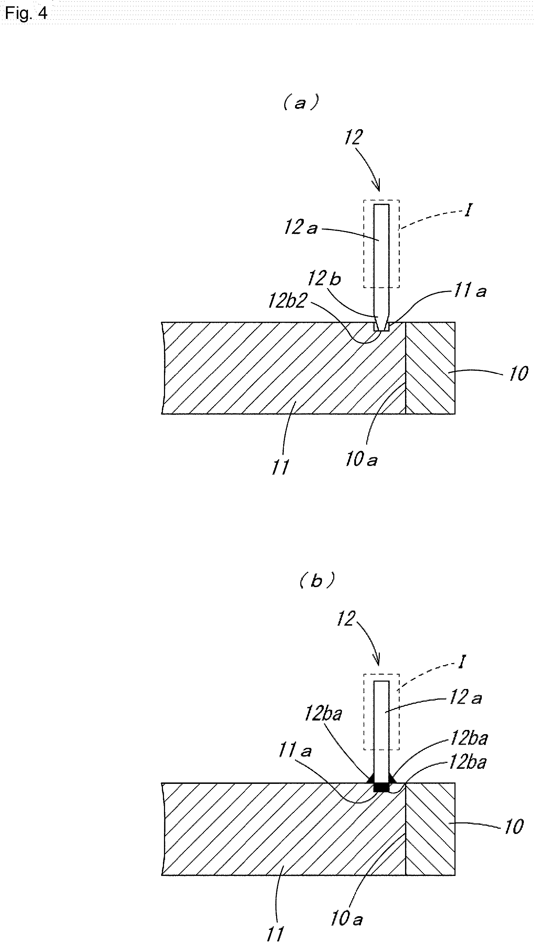

Fig. 4 shows a manufacturing process of a shunt resistor according to another embodiment, and Fig. 4(a) is a partial half sectional view showing a state in which a recessed hole is formed in a base member and a distal end surface of a protruding part of a measurement terminal with its shaft part inserted in an electrode of an electric resistance welding machine is inserted into and brought into contact with the recessed hole according to the same embodiment, and Fig. 4(b) is a partial half sectional view showing a state in which the protruding part is melted by flowing a current to the electrode in the state shown in Fig. 4(a), whereby the base member and a side circumferential surface of the shaft part are welded.

### [Mode for Carrying out the Invention]

Hereinafter, one embodiment of a shunt resistor according to the present invention will be specifically described with reference to the drawings. It is noted that, in the following description, up/down and left/right directions shall be referred to as up/down and left/right directions when viewed from the front of the figure.

The shunt resistor according to the present embodiment is particularly used in measuring a current value of a current path through which a large current flows from a battery for high-voltage applications to a motor circuit that are used in, for example, electric vehicles (EVs), hybrid vehicles (HVs), and plug-in hybrid vehicles (PHVs). As shown in Fig. 1(a) and Fig. 1(b), a shunt resistor 1 is composed of a resistor 10, a pair of base members 11 integrally formed with the resistor 10 so as to sandwich the resistor 10, and a measurement terminal 12 erected and fixed on each of the pair of the base members 11. As shown in Fig. 1(a), the resistor 10 is formed in, for example, a thick plate-like short rectangular shape having a thickness of about 3 mm to 5 mm, and preferably formed of, for example, Cu-Mn alloys, Cu-Ni alloys, or Ni-Cr alloys, and is a resistor on the order of 50 µΩ to 200 µΩ. On both side surfaces 10a, 10b of the resistor 10 thus formed, the base member 11 located on the left in the figure is joined by welding to one of the side surfaces 10a of the resistor 10, and the base member 11 located on the right in the figure is joined by welding to the other side surface 10b of the resistor 10 as shown in Fig. 1(a) and Fig. 1(b). As a result, the pair of base members 11 are integrally formed with the resistor 10 so as to sandwich the resistor 10.

On the other hand, the base member 11 is a so-called bus bar, formed of metal such as copper, and formed in, for example, a thick plate-like long rectangular shape having a thickness of about 3 mm to 5 mm as shown in Fig. 1(a).

On the other hand, the measurement terminal 12 is capable of mounting thereon a printed circuit board for current detection, and formed of copper or tin plating, and formed with a length H1 (for example, about 15.5 mm) as shown in Fig. 2(a). The measurement terminal 12 is composed of a rod-like shaft part 12a and a substantially inverted conical protruding part 12b provided in a manner integrally protruding from a distal end of the shaft part 12a. The shaft part 12a is a current measurement terminal used in measuring a current value, and has a diameter φ1 formed at, for example, about 1.5 mm and a length H2 formed at, for example, about 14.5 mm.

On the other hand, as shown in Fig. 2(b), the projecting part 12b is formed in a substantially inverted cone shape, and the length H1-H2 is formed at, for example, about 1.0 mm. The diameter of a proximal end surface 12b1 is the same as the diameter φ1 of the shaft part 12a and is formed at, for example, about 1.5 mm. The diameter φ2 of a distal end surface 12b2 is formed at, for example, about 0.3 mm. In other words, the protruding part 12b has a shape tapered from the proximal end surface 12b1 toward the distal end surface 12b2. As shown in Fig. 2(b), the angle θ on the distal end surface 12b2 side of the protruding part 12b tapered from the proximal end surface 12b1 toward the distal end surface 12b2 is formed at, for example, about 90 degrees.

Thus, the protruding part 12b formed in this manner is melted by inserting the shaft part 12a into an electrode I of an electric resistance welding machine as shown in Fig. 3(a) and flowing a current in this state, and becomes a welding material 12ba as shown in Fig. 1 and Fig. 3(b), therewith welding the base member 11 and the side circumferential surface of the shaft part 12a. By this, the measurement terminal 12 (the shaft part 12a) is erected and fixed on the base member 11 as shown in Fig. 1.

Therefore, as just described, the substantially inverted conical protruding part 12b integrally protruding from the distal end of the shaft part 12a is melted to become the welding material 12ba by inserting the shaft part 12a into the electrode I of the electric resistance welding machine and flowing a current in this state. Since the welding material 12ba is such that the protruding part 12b integrally protruding from the distal end of the shaft part 12 is melted, the welding material 12ba can weld the shaft part 12a erected and fixed on the base member 11 in close contact with the protruding part 12b. By this, withstand loads in the axial direction (the upward direction) and the radial direction (the left/right direction) of the shaft part 12a with respect to the base member 11 can be improved, whereby a sufficient joining strength can be obtained.

By the protruding part 12b being formed in the shape tapered from the proximal end surface 12b1 toward the distal end surface 12b2, a current is easily concentrated on the distal end surface 12b2 side of the protruding part 12b when the shaft part 12a is inserted into the electrode I of the electric resistance welding machine and a current is flowed in this state. As a result, the protruding part 12b becomes easy to melt and thus can weld the shaft part 12a on the base member 11 more firmly. More specifically, where the protruding part 12b is formed simply flat, that is, in a rectangular shape but not the shape tapered from the proximal end surface 12b1 toward the distal end surface 12b2, the flowed current is easily dispersed, and thus, the protruding part 12b becomes difficult to melt. Accordingly, it is preferable that the protruding part 12b is formed in the shape tapered from the proximal end surface 12b1 toward the distal end surface 12b2. The angle θ on the distal end surface 12b2 side of the protruding part 12b is preferably set to 90 degrees.

Further, as the electric resistance welding machine, it is preferable to use one which can output a large current in a short time. More specifically, where the base member 11 is formed of copper and the measurement terminal 12 is formed of copper, a large current is required in a short time for joining copper together since copper has a property that electricity is easily transmitted and heat is easily dissipated. Thus, it is preferable to use an electric resistance welding machine capable of outputting a large current in a short time. If an electric resistance welding machine which is unable to output a large current in a short time is used, it takes a lot of time when the base member 11 and the measurement terminal 12 are joined (the protruding part 12b of the measurement terminal 12 is melted and the shaft part 12a is joined on the base member 11). As a result, the structure of the joining part may be broken. When the structure of the joining part is broken, the resistance value is increased due to the structure breakdown, which leads to a problem that the current value cannot be measured accurately. Therefore, as the electric resistance welding machine, it is preferable to use one which can output a large current in a short time. For example, an inverter type electric resistance welding machine and a capacitor type electric resistance welding machine are exemplified as such an electric resistance welding machine.

Now, a method for manufacturing the shunt resistor 1 configured as above will be specifically described with reference to Fig. 3.

First, as shown in Fig. 3(a), the measurement terminal 12 is erected in the vicinity of the resistor 10 on the pair of base members 11 integrally formed with the resistor 10 so as to sandwich the resistor 10. More specifically, the distal end surface 12b2 of the protruding part 12b of the measurement terminal 12 with the shaft portion 12a inserted in the electrode I of the electric resistance welding machine is brought into contact with the upper surface of the base member 11, by which the measurement terminal 12 is erected in the vicinity of the resistor 10 on the pair of base members 11.

By flowing a current to the electrode I in this state, the current is concentrated on the distal end surface 12b2 side of the protruding part 12b, and then the protruding part 12b is melted to become the welding material 12ba as shown in Fig. 3(b). As a result, the base member 11 and the side circumferential surface of the shaft part 12a are welded, and the measurement terminal 12 is erected and fixed on each of the pair of base members 11. Then, the shunt resistor 1 as shown in Fig. 1(a) is manufactured.

Thus, according to the present embodiment as described above, the protruding part 12b integrally protruding from the distal end of the shaft part 12a is melted to become the welding material 12ba by inserting the shaft part 12a into the electrode I of the electric resistance welding machine and flowing a current in this state. Since the welding material 12ba is such that the protruding part 12b integrally protruding from the distal end of the shaft part 12a is melted, the welding material 12ba can weld the shaft part 12a erected and fixed on the base member 11 in close contact with the protruding part 12b. By this, withstand loads in the axial direction (the upward direction) and the radial direction (the left/right direction) of the shaft part 12a with respect to the base member 11 can be improved, whereby a sufficient joining strength can be obtained.

According to the present embodiment, there is no need to provide through holes as in the conventional manner. Therefore, the measurement terminal 12 can be erected and fixed on each of the pair of base members 11, regardless of the thickness of the base member 11. Therefore, although the thickness of the base member 11 needs to be thickened but the diameter of the shaft part 12a needs to be made small so as not to reduce the detection accuracy of the current measurement especially when a large current is flowed from a battery for high-voltage applications to a motor circuit that are used in, for example, electric vehicles (EVs), hybrid vehicles (HVs), and plug-in hybrid vehicles (PHVs), the present embodiment can cope with such requirements as well.

Further, in general, when a through hole having a diameter not greater than the thickness of the base member 11 is attempted to be provided in the base member 11, a drill is broken in the middle of forming the through hole or when the drill is removed from the through hole after the formation, when drilling is performed. Thus, there is a problem that burrs are generated in the through hole and the through hole cannot be provided at an accurate position. However, according to the present embodiment, such a problem cannot arise since the through hole does not need to be provided as in the conventional manner.

Meanwhile, the measurement terminal 12 is provided in the vicinity of the resistor 10 as shown in Fig. 1. This is because noise at the time of measuring a current can be reduced when the measurement terminal 12 is configured to be provided in the vicinity of the resistor 10, whereby the detection accuracy of the current measurement can be improved. Accordingly, the measurement terminal 12 is provided in the vicinity of the resistor 10. However, when the measurement terminal 12 comes into contact with the resistor 10, the detection accuracy of the current measurement results in being reduced. Thus, the measurement terminal 12 needs to be provided in the vicinity of the resistor 10 so as not to come into contact. Therefore, the position of the measurement terminal 12 is important.

In this respect, the through hole does not need to be provided as in the conventional manner in the present embodiment. Therefore, when the measurement terminal 12 is erected and fixed on each of the pair of base members 11, the position can be changed freely. Thus, the measurement terminal 12 can be provided in the vicinity of the resistor 10 so that the measurement terminal 12 does not come into contact with the resistor 10.

On the other hand, when the measurement terminal 12 needs to be erected and fixed in the vicinity of the resistor 10 more accurately so that the measurement terminal 12 does not come into contact with the resistor 10, a recessed hole 11a having, for example, a diameter of about 1.0 mm and a depth of about 0.5 mm may be formed in the upper surface of the base member 11, that is, in the vicinity of both side surfaces 10a, 10b of the resistor 10, as shown in Fig. 4(a). By doing this, the measurement terminal 12 can be erected and fixed using the recessed hole 11a as a mark when the measurement terminal 12 is erected and fixed in the vicinity of the resistor 10 so that the measurement terminal 12 does not come into contact with the resistor 10. Thus, the positioning accuracy is improved.

More specifically, when forming the recessed hole 11a like this, the recessed hole 11a is formed by punch press processing in the vicinity of the resistor 10 in each of the pair of base members 11 integrally formed with the resistor 10 so as to sandwich the resistor 10, as shown in Fig. 4(a). When the recessed hole 11a is configured to be formed by punch press processing in this manner, the positioning accuracy is increased and also continuous production at high speed becomes possible. In greater detail, the thickness of the base member 11 needs to be thickened but the diameter of the shaft part 12a needs to be made small so as not to reduce the detection accuracy of the current measurement, especially when a large current is flowed from a battery for high-voltage applications to a motor circuit that are used in, for example, electric vehicles (EVs), hybrid vehicles (HVs), and plug-in hybrid vehicles (PHVs). Accordingly, when a through hole having a diameter (for example, about 1.0 mm) not greater than the thickness (for example, about 3 mm to 5 mm) of the base member 11 is attempted to be provided in the base member 11, instead of the recessed hole 11a, a drill is broken in the middle of forming the through hole or when the drill is removed from the through hole after the formation, when drilling is performed. Thus, there is a problem that burrs are generated in the through hole and the through hole cannot be provided at an accurate position. Moreover, when the through hole like the above is attempted to be provided by punch press processing, it causes wear of the punch. Thus, there is a problem that workability is reduced and the through hole cannot be provided at an accurate position and the punch press processing is not suitable for continuous production at high speed.

Thus, the foregoing problems are intended to be solved by forming the recessed hole 11a by punch press processing, instead of the through hole, in the present embodiment. That is, when the recessed hole 11a but not the through hole is configured to be formed by punch press processing, there is no need to penetrate the base member 11, so that the situation where the punch is worn can be reduced. Thus, reduction in workability can be reduced. Consequently, the recessed hole 11a can be provided at an accurate position and the continuous production at high speed becomes possible. Thus, since the recessed hole 11a is formed by punch press processing in the present embodiment, the positioning accuracy is increased and also the continuous production at high speed becomes possible. In this respect, when forming the recessed hole 11a, the recessed hole 11a may be formed by drilling. However, a displacement can occur and there is a possibility that the recessed hole 11a cannot be formed at an accurate position. Therefore, the recessed hole 11a is preferably formed by punch press processing.

After the recessed hole 11a with high positioning accuracy as above is thus formed by punch press processing in the vicinity of the resistor 10 in the pair of base member 11, the distal end surface 12b2 of the protruding part 12b of the measurement terminal 12 with the shaft part 12a inserted in the electrode I of the electric resistance welding machine is inserted into the recessed hole 11a and brought into contact therewith, by which the measurement terminal 12 is erected in the vicinity of the resistor 10 in the pair of base members 11, as shown in Fig. 4(a).

By flowing a current to the electrode I in this state, the current is concentrated on the distal end surface 12b2 side of the protruding part 12b, then, the protruding part 12b is melted to become the welding material 12ba as shown in Fig. 4(b). By this, the welding material 12ba fills in the recessed hole 11a. Further, the welding material 12b having not been accommodated within the recessed hole 11a leaks out. The welding material 12b having leaked out welds the base member 11 and the side circumferential surface of the shaft part 12a. Therefore, in this manner, the measurement terminal 12 is erected and fixed on each of the pair of base members 11, and the shunt resistor as shown in Fig. 1(a) is manufactured.

As just described, the positioning accuracy is improved when the recessed hole 11a is configured to be thus formed in the upper surface of the base member 11, that is, in the vicinity of both side surfaces 10a, 10b of the resistor 10.

The shapes of the shunt resistor 1, resistor 10, base member 11, and measurement terminal 12 exemplified in the present embodiments are mere examples, and various modifications and changes can be made within the scope of the gist of the present invention described in the claims.

### [Industrial Applicability]

It is useful that the shunt resistor 1 exemplified in the present embodiments is particularly used in measuring a current value of a current path through which a large current flows from a battery for high-voltage applications to a motor circuit that are used in, for example, electric vehicles (EVs), hybrid vehicles (HVs), and plug-in hybrid vehicles (PHVs).

### [Description of Numerals]

- 1: Shunt Resistor
- 10: Resistor
- 11: Base Member
- 11a: Recessed Hole
- 12: Measurement Terminal
- 12a: Shaft Part
- 12b: Protruding Part
- 12b1: Proximal End Surface
- 12b2: Distal End Surface
- 12ba: Welding Material
- I: Electrode (of Electric Resistance Welding Machine)

## Claims

1. A method of manufacturing a shunt resistor, the shunt resistor having
a resistor (10);
a pair of base members (11) sandwiching the resistor (10) and integrally formed with the resistor (10); and
a measurement terminal (12) fixed on the base member (11),
wherein the measurement terminal (12) has
a shaft part (12a); and
a protruding part (12b) integrally protruding from a distal end side of the shaft part (12a),
**characterized in that** the protruding part (12b) is formed in a tapered shape, when welding the base member (11) and the side circumferential surface of the shaft part (12a),
the protruding part (12b), formed in the tapered shape, is melted to become a welding material (12ba) by inserting the shaft part (12a) into an electrode of an electric resistance welding machine and flowing a current in this state, therewith welding the base member (11) and the side circumferential surface of the shaft part (12a).

2. The method of manufacturing of the shunt resistor according to claim 1, **characterized in that** the electric resistance welding machine is an inverter-type or capacitor-type electric resistance welding machine, when the base member (11) is formed of copper and the measurement terminal (12) is formed of copper and the base member (11) and the measurement terminal (12) are joined together, the electric resistance welding machine can join them in a short time so that a structure of the joining part is not broken.

## Patentansprüche

1. Verfahren zur Herstellung eines Shunt-Widerstands, wobei der Shunt-Widerstand Folgendes aufweist
einen Widerstand (10);
ein Paar Basiselemente (11), die den Widerstand (10) zwischen sich aufnehmen und mit dem Widerstand (10) einstückig gebildet sind; und
einen an dem Basiselement (11) befestigten Messanschluss (12),
wobei der Messanschluss (12) Folgendes aufweist
einen Schaftteil (12a); und
einen Vorsprungsteil (12b), das einstückig von einer distalen Endseite des Schaftteils (12a) hervorsteht,
**dadurch gekennzeichnet, dass** das Vorsprungsteil (12b) in einer sich verjüngenden Form ausgebildet wird, beim Schweißen des Basiselements (11) und der Mantelfläche des Schaftteils (12a),
das in der sich verjüngenden Form ausgebildete Vorsprungsteil (12b) geschmolzen wird, um zu einem Schweißmaterial (12ba) zu werden, indem das Schaftteil (12a) in eine Elektrode einer Widerstandsschweißmaschine eingeführt und ein Strom in diesem Zustand durchgeleitet wird, wodurch das Basiselement (11) und die Mantelfläche des Schaftteils (12a) geschweißt werden.

2. Verfahren zur Herstellung des Shunt-Widerstands nach Anspruch 1, **dadurch gekennzeichnet, dass** die Widerstandsschweißmaschine eine Widerstandsschweißmaschine des Wechselrichtertyps oder des Kondensatortyps ist, wobei, wenn das Basiselement (11) aus Kupfer gebildet ist und der Messanschluss (12) aus Kupfer gebildet ist und das Basiselement (11) und der Messanschluss (12) miteinander verbunden werden, die Widerstandsschweißmaschine sie in kurzer Zeit verbinden kann, sodass eine Struktur des Verbindungsabschnitts nicht zerstört wird.

## Revendications

1. Procédé de fabrication d'une résistance shunt, la résistance shunt présentant
une résistance (10) ;
une paire d'éléments de base (11) enserrant la résistance (10) et formés d'un seul tenant avec la résistance (10) ; et
une borne de mesure (12) fixée sur l'élément de base (11),
dans lequel la borne de mesure (12) a
une partie de tige (12a) ; et
une partie saillante (12b) formant intégralement saillie du côté de l'extrémité distale de la partie de tige (12a),
**caractérisé en ce que** la partie saillante (12b) est formée dans une forme effilée, lors du soudage de l'élément de base (11) et de la surface latérale circonférentielle de la partie de tige (12a),
la partie saillante (12b), formée dans la forme effilée, est fondue pour devenir un matériau de soudage (12ba) par insertion de la partie de tige (12a) dans une électrode d'une machine de soudage par résistance électrique et par circulation d'un courant dans cet état, soudant par cela l'élément de base (11) et la surface latérale circonférentielle de la partie de tige (12a).

2. Procédé de fabrication de la résistance shunt selon la revendication 1, **caractérisé en ce que** la machine de soudage par résistance électrique est une machine de soudage par résistance électrique de type onduleur ou de type à condensateur, lorsque l'élément de base (11) est formé de cuivre et que la borne de mesure (12) est formée de cuivre et que l'élément de base (11) et la borne de mesure (12) sont joints ensemble, la machine de soudage par résistance électrique peut les joindre en un temps court de sorte que la structure de la partie de jonction n'est pas rompue.
